# EUROPEAN PATENT SPECIFICATION

(11) **EP 4 022 492 B1**
(45) Date of publication and mention of the grant of the patent: **07.08.2024**
(21) Application number: 20860574.1
(22) Date of filing: 03.09.2020
(51) Int. Cl.: G06K 7/10

(54) **METHOD OF PROCESSING A SIGNAL OF A PASSIVE RFID CHIP WITH A READER**
VERFAHREN ZUR VERARBEITUNG EINES SIGNALS EINES PASSIVEN RFID-CHIPS MIT EINEM LESEGERÄT
PROCÉDÉ DE TRAITEMENT D'UN SIGNAL D'UNE PUCE RFID PASSIVE AU MOYEN D'UN LECTEUR

(30) Priority: 03.09.2019 CZ 20195630
(43) Date of publication of application: 06.07.2022
(73) Proprietor: Y Soft Corporation, 61600 Brno (CZ)
(72) Inventor: KASÍK, Vladislav, 14000 Praha (CZ); STANEK, Pavel, 13000 Praha (CZ)
(74) Representative: Dadej, Leopold
(86) International application number: PCT/CZ2020/050064
(87) International publication number: WO 2021/043348

(56) References cited:
- EP-A1- 1 871 062
- WO-A1-2004/030300
- WO-A2-2014/210183
- US-A1- 2009 096 520
- No further relevant documents disclosed
- FERNANDO PAIXAO CORTES ET AL.: "Low- Power /Low-Voltage analog front-end for LF passive RFID tag systems", 2013 26TH SYMPOSIUM ON INTEGRATED CIRCUITS AND SYSTEMS DESIGN (SBCCI, 2 September 2013 (2013-09-02), Curitiba, Brazil, XP032514561, ISBN: 978-1-4799-1132- 5, Retrieved from the Internet <URL:https://ieeexplore.ieee.org/abstract/document/6644868> [retrieved on 20201210], DOI: 10.1109/SBCCI.2013.6644868
- JAN NOVOTNY : "Signal processing for UHF RFID reader ", MASTER'S THESIS, 2015, pages 1 - 83, XP055910707

## Description

### Field of the Invention

The invention relates a method of processing a signal of a passive RFID chip operating in the area of low frequencies (LF), most commonly the frequency 125 kHz, in order to amplify the useful signal and improve the quality of reading of LF RFID contactless cards.

### Background of the Invention

The method of contactless transfer of data based on transmitting, receiving and processing of a radio signal, also known as RFID (radio-frequency identification), is used more and more nowadays. This technology, applicable for example in identification cards for attendance records, for identification of components in device during manufacture or for contactless authorization for devices such as printers or photocopiers, uses signal transfer between a reader and a so-called tag (a card, a chip), with an integrated antenna and an integrated circuit for generating its own signal. The present solution relates to a method of processing a signal of a passive RFID chip, i.e. a chip or a card without energy source, which are fed by the electromagnetic energy from the reader. In a simplified arrangement the chip antenna receives a signal transmitted by the reader antenna and uses the received energy to power its internal integrated circuit, which starts to produce its own signal and transmits it by means of the antenna back to the reader. In practice, however, there are problems with reading contactless cards, particularly in terms of the strength of the signal. There are ways to amplify the signal by means of additional external components, but this process means considerable costs as well as higher bias. Therefore, it is desirable to provide a solution that uses a different mechanism to amplify the signal.

Solutions are known in the state of the art which use positive and negative signal values when processing a signal. Patent document WO200880758 A1 discloses a demodulator of an amplitude modulated signal - a so-called ASK demodulator, which comprises a positive and a negative branch, which allow simultaneous demodulation of a positive and negative half period signal, wherein the demodulation process is performed in these individual branches. However, this document does not disclose signal shifting by means of an operational amplifier functionally connected as a summing amplifier. A considerable disadvantage of the disclosed solution is particularly its limitation to processing just the amplitude modulated signal, wherein in the field of RFID technologies there are also devices working with a frequency (FSK) or phase (PSK) modulated signal.

European patent EP0545254 B1 further discloses an analogue-digital converter (ADC) characterized by automatic convertor range control. Apart from the AD converter itself, the disclosed solution includes a peak detector, which is used for providing a reference potential on the basis of the detected signal peak amplitude, and a circuit ensuring a shift of a signal direct level while taking in account the reference potential so that the signal is in the AD converter range. In a specific example embodiment the signal shift is ensured by a sum of a half the value of the input analogue signal and a half the value of the reference potential, not using the operational amplifier. Such shifted signal is further processed by the AD converter, wherein the automatic control of the converter range is ensured by the reference potential taking a new value with every detection of a new peak. In addition, this document does not disclose a potential use of such solution in the field of RFID technologies.

The principle of signal shifting for use in a RFID reader is also published in a European patent application EP1538546 A2, which discloses a solution including a circuit for stripping a signal so that only its certain part is further processed by a reader. This circuit can be preferably used for stripping a signal, for example, around a peak. However, no operational amplifier is used to shift the signal, in contrast to the present invention, and the purpose of the solutions is also different. Signal shifting is in the mentioned patent application used for amplifying relatively small voltage deviations that comprise readable information, not for processing of the input signal for the AD converter.

Document WO2014210183A2 discloses an apparatus and method for RFID card learning. An AD converter is used for signal processing in this document. However, no signal shifting is mentioned in order to improve reading of the RFID signal. Document US2009096520A1 describes an RFID signal detector. No improvement in signal strength or reading quality or utilization of signal shifting is mentioned in this document. Signal shifting as a part of RFID signal demodulation method is described in document WO2004030300A1. The signal is split into two components with the same polarization and opposite phases, which are than combined using an AND function.

At present, solutions utilizing an operational amplifier in a special connection to shift the signal are known, which allows the signal to be further processed by the AD converter also when this converter has a smaller range than the amplitude of the input signal. However, the disclosed solution, apart from the signal shifting mechanism itself for AD converter processing, does not use any combination of AD converter output values in order to amplify the useful signal and improve the quality of reading of LF RFID contactless cards.

### Summary of the Invention:

The invention is set out in the independent claims.

The above-mentioned shortcomings are at least partially eliminated by a method of processing a signal of a passive RFID chip by a reader the essence of which is based on the fact that the reader comprises an antenna, an operational amplifier, an AD converter, and a first DA converter and further a second DA converter or a source of constant voltage, and that this method consists of steps of transferring of a source signal of the antenna, receiving a source signal of the antenna by the RFID chip, transferring the RFID chip signal and receiving of the RFID chip signal by the antenna, wherein the received RFID chip signal and the output of the first DA converter is fed to the inverting input of the operational amplifier, and the output of the second DA converter or the output of the source of constant voltage is fed to the non-inverting input of the operational amplifier.

The advantage of the present solution as compared to the standard method of processing a signal of an RFID chip is particularly the use of the useful signal both in the positive and in the negative half period. In order for this signal to be further processed by the AD converter, it is shifted by the operational amplifier functionally connected as a summing amplifier. To shift a signal in such a way that the AD converter processes the useful signal of a positive, or a negative, peak, a suitably set voltage ratio value DAC1 is used at the first DA converter, the output of which is fed to the inverting input of the operational amplifier, and DAC2 voltage at the second DA converter or the source of constant voltage, the output of which is fed to the non-inverting input of the operational amplifier. Calibration helps to find the first pair of values Pos1 and Pos2 of voltage for controlling the first and the second DA converter or the source of constant voltage, wherein the values Pos1 and Pos2 are chosen in such way that the window of the operational amplifier scans the positive half wave of the received RFID chip signal; and the second pair of values Neg1 and Neg2 of voltage for controlling the first and the second DA converter or the source of constant voltage, wherein the values Neg1 and Neg2 are chosen in such way that the window of the operational amplifier scans the negative half wave of the received RFID chip signal.

After converting the signal by the AD converter, when processing the buffer, the amplitudes of two consecutive peaks are subtracted, which can help to obtain a stronger signal, even without using costly additional external components, wherein such solution leads to increase in the reader sensitivity, thanks to which it is also possible to process weak signals from LF RFID cards. In a preferred embodiment the individual signals at the output of the AD converter are before subtraction temporarily stored in the buffer and the final digitally processed signal is subsequently stored in a data structure (queue) to prevent data overflow.

The effect of increasing the magnitude of the RFID chip signal is observed for all types of signal modulation (ASK, FSK and PSK; i.e. amplitude, frequency and phase), wherein another shortcoming is removed in PSK cards by this process. In standard PSK card signal transmission, different modulation of individual half waves occurs based on which side of the card is placed on the reader, leading to a different reading distance from different card sides. The present method of RFID chip signal processing can be preferably used for example for contactless authorization for devices, such as printers or photocopiers.

The reader for the above-mentioned method of processing the signal of the passive RFID chip comprises at least an antenna adapted to transmit a source signal and detect a passive RFID chip signal, a control unit electrically connected to the antenna and adapted to excite the antenna, a first DA converter and a second DA converter or a source of constant voltage, a synchronizing unit, an AD converter, and an operational amplifier. The synchronizing unit is electrically connected to the first DA converter and further to the second DA converter or the source of constant voltage, the control unit, and the AD converter and it is adapted to time synchronize all components with which it is directly and/or indirectly electrically connected. Outputs of the antenna and the first DA converter are fed to the inverting input of the operational amplifier. The output of the second DA converter or the source of constant voltage is then fed to the non-inverting input of the operational amplifier. The output of the operational amplifier is subsequently fed to the input of the AD converter, wherein the operational amplifier is connected as the summing operational amplifier.

In order for the operational amplifier to exhibit the defined behavior also outside the operation range, the input of the operational amplifier must be of a rail-to-rail type. In a preferred embodiment the output of the operational amplifier is also of the rail-to-rail type. The control unit in the preferred embodiment comprises a transistor of a push-pull MOSFET type.

### Description of Drawings

The summary of the invention is further shown in exemplary embodiment which are described with references to the accompanying drawings, where:
Fig. 1 shows a schematic representation of connection of a reader for performing a method of processing a signal of a passive RFID chip,
Fig. 2 shows a schematic representation of connection of a summing operational amplifier to the resonant antenna circuit and individual components integrated in the MCU unit.

### Exemplary embodiments of the Invention

The invention will be further described by means of exemplary embodiments with references to the accompanying drawings.

A method of processing a signal of a passive RFID chip 1 by a reader 2 comprising an antenna 3, an operational amplifier 4, an AD converter 5 and a first DA converter 6 and a second DA converter 7 or a source of constant voltage consists of steps of transmitting the source signal of the antenna 3, receiving the source signal of the antenna 3 by the RFID chip 1, transmitting the RFID chip 1 signal and receiving the RFID chip 1 signal by the antenna 3, wherein the received RFID chip 1 signal and the output of the first DA converter 6 is fed to the inverting input of the operational amplifier 4, and the output of the second DA converter 7 or the output of the source of constant voltage is fed to the non-inverting input of the operational amplifier 4.

The processing of the signal of the RFID chip 1 by the reader 2 is preceded by three calibration procedures which include tuning of the antenna 3 and then further phase calibration of the reader 2 and calibration of voltage values at the output of the first DA converter 6 and the second DA converter 7 or the source of constant voltage which are connected individually to the inverting and non-inverting input of the operational amplifier 4. The tuning of the antenna 3 is performed by means of a number of external tuning condensers and is performed in such way that the antenna 3 shows the highest amplitude of the signal at the required frequency of 125 kHz. Voltage at the antenna 3 is measured by a capacitor divider for converting the voltage into the AD converter 5 range, wherein a secondary input of the AD converter 5 is used for the measurement.

Calibration of the reader 2 consists primarily in the correct determination of the phase of the input signal of the AD converter 5 relative to the phase of the synchronizing unit 11 which is necessary for processing of the signal by the AD converter 5 exactly in given extremes, i.e. in positive and negative signal peaks, since in positive and negative half waves pulses corresponding to transferred information of the RFID chip 1 are detected.

In order to shift the signal in such way that the AD converter 5 processes the useful signal of the positive or the negative peak, a suitably set value of voltage ratio DAC1 is used at the first DA converter 6, the output of which is fed to the inverting input of the operational amplifier 4, and DAC2 voltage at the second DA converter 7 or the source of constant voltage, the output of which is fed to the non-inverting input of the operational amplifier 4. The operational amplifier 4 is connected as a summing amplifier and in the preferred embodiment the output of the operational amplifier 4 is of a rail-to-rail type. The input of the operational amplifier 4 must be of the rail-to-rail type to ensure its defined behavior even outside the operational range. The third step of the calibration process consists in finding optimum values of voltage DAC1 and DAC2, wherein specifically values Pos1 and Pos2 representing voltage DAC1 and DAC2 are chosen when the window of the operational amplifier 4 scans the positive half wave of the received signal, and values Neg1 and Neg2 representing voltage DAC1 and DAC2 when the window of the operational amplifier 4 scans the negative half wave of the received signal. Thus the change in voltage DAC1 and DAC2 ratio used in further process of the present solution is ensured by change of both these values, which allows signal shifting in a wider range than in an arrangement where one of these values stays constant.

Searching for optimum values of Pos1, Pos2, Neg1 and Neg2 is performed by a gradual change of voltage DAC1 and DAC2 using binary search. This algorithm is based on the principle of comparing a candidate of the searched value with the median of arranged series of elements and determining the half of the interval in which the searched value cannot appear. The calibration is performed in such way that optimum values Pos1 and Pos2, or Neg1 and Neg2, are simultaneously determined, wherein the order of operations is not decisive for further function of the present solution; however, the calibration output must include all four searched optimum values. Of course, it is not possible to determine optimum values, one of which corresponds to the setting of the reading window of the operational amplifier 4 for processing the positive half wave and the other corresponds to the setting of the reading window of the operational amplifier 4 for processing the negative half wave, i.e., for example, Pos1 and Neg2, or Pos2 and Neg1. In a preferred embodiment the values Pos1, Pos2, Neg1 and Neg2 are chosen so that the mean value of the useful signal is in the center of the area intended for conversion by the AD converter 5.

After performing each of the above-mentioned calibration procedures, it is possible to perform the processing of the RFID chip 1 signal. The first DA converter 6 and further the second DA converter 7 or the source of constant voltage are controlled by DMA (Direct Memory Access) and are configured so that in the first channel 8 at a required moment voltage DAC1 is set to a Pos1 or Neg1 value depending on whether at the given moment it is desired for the reading window of the operational amplifier 4 to scan positive or negative half wave of the received signal. In the second channel DMA 9 voltage DAC2 is at the same time set to a Pos2 or Neg2 value, wherein for the correct shift of the reading window of the operational amplifier 4 it is necessary that only pairs of values of Pos1 and Pos2, or Neg1 and Neg2, are at the same time set in the individual channels DMA 8-9, according to the performed calibration.

Both channels DMA 8-9 are further configured to a circular continual mode which ensures regular change of voltage DAC1 and DAC2 for the shift of the reading window of the operational amplifier 4 to a position of the specific maximum, so that the positive and negative peak are alternately processed by the AD converter 5, since pulses corresponding to the transferred information of the RFID chip 1 are detected in positive and negative half waves. Each channel DMA 8,9 includes only two voltage values which are alternately applied in regular intervals, wherein in the case of the first channel DMA 8, which corresponds to the voltage DAC1, these are the values Pos1 and Neg1, and in the case of the second channel DMA 9, which corresponds to the voltage DAC2, these are the values Pos2 and Neg2. The change in the ratio of voltage DAC1 and DAC2 is preferably ensured by the change of both of these values, which allows shifting the signal in a wider range than in the arrangement where one of these values stays constant.

The AD converter 5 is configured to continuously alternately process positive and negative peaks of the input signal, wherein the synchronization of the AD converter 5 with the first DA converter 6 and further with the second DA converter 7 or the source of constant voltage, the outputs of which are connected individually to the inverting and the non-inverting input of the operational amplifier 4, and with the control unit 10 for exciting the antenna 3, is performed by the synchronizing unit 11. The control unit 10 is in the preferred embodiment for example a MOSFET transistor with a push-pull output circuit. In another exemplary embodiment the antenna 3 can be excited by logical circuit gates.

After converting the signal by the AD converter 5, the amplitude of two consecutive peaks corresponding to a single wave is subtracted, wherein the individual signals are temporarily stored in the buffer 12 before subtraction. The final digitally processed signal is subsequently stored in the data structure, specifically in the queue 13 to prevent data overflow.

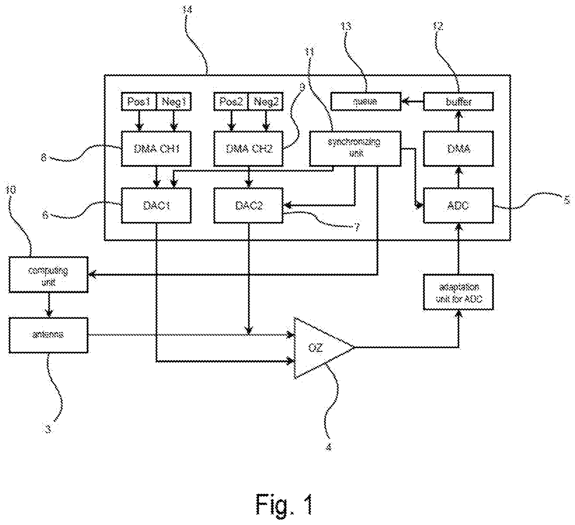

In an exemplary embodiment of the invention according to Fig. 1 the reader 2 comprises, in order to perform the method of processing the signal of the passive RFID chip 1, the antenna 3 adapted to transmit the source signal and detect the signal of the passive RFID chip 1, the control unit 10 electrically connected to the antenna 3 and adapted to excite the antenna 3, the first DA converter 6 and further the second DA converter 7 or the source of constant voltage, the synchronizing unit 11, the AD converter 5 and the operational amplifier 4 connected as a summing amplifier. The synchronizing unit 11 is electrically connected with the first DA converter 6 and further with the second DA converter 7 or the source of constant voltage, the control unit 10 and the AD converter 5 and adapted to time synchronize all components with which it is directly and/or indirectly electrically connected, wherein the outputs of the antenna 3 and the first DA converter 6 are fed to the inverting input of the operational amplifier 4, the output of the second DA converter 7 or the source of constant voltage is fed to the non-inverting input of the operational amplifier 4 and the output of the operational amplifier 4 is fed to the input of the AD converter 5.

The scheme of the connection of the reader 2 for performing the method of processing the signal of the passive RFID chip 1, shown in Fig. 1, also includes, in addition to the above-mentioned components, an MCU (Microcontroller Unit) unit 14, with an integrated first DA converter 6 and further a second DA converter 7 or a source of constant voltage, corresponding DMA channels 8-9 configured to calibrated values Pos1, Pos2, Neg1 and Neg2 for controlling the first DA converter 6 and further the second DA converter 7 or the source of constant voltage, an AD converter 5, a synchronizing unit 11 for time synchronization of all components with which it is directly and/or indirectly electrically connected, further a buffer 12 for temporary storing of output data of the AD converter 5 before its subtraction and a queue 13 in which the final digitally processed signal is stored to prevent data overflow.

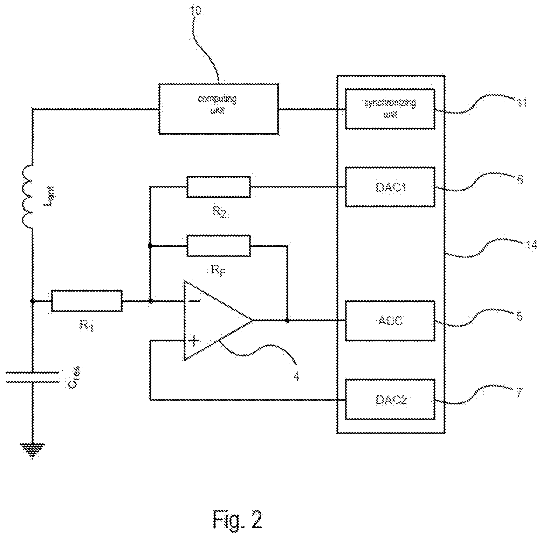

In addition to the MCU unit 14, a control unit 10, an antenna 3 and an operational amplifier 4 as well as an adaptation member connected at the output of the operational amplifier 4 are connected. The connection of the summing operational amplifier 4 to the resonant circuit of the antenna 3 and to the individual components integrated in the MCU unit 14 is shown in Fig. 2. In an exemplary embodiment of the invention according to Fig. 2 the radiofrequency electromagnetic field is excited by the antenna 3 by the control unit 10, controlled from the synchronizing unit 11.

The resonant circuit of the antenna 3 comprises a condenser with the capacity *C*ᵣₑₛ ideally in the range of values of 1-4 nF and a coil with the inductance *L*ₐₙₜ, ideally in the range of values of 600-650 µH, wherein the acceptable inductance in this exemplary embodiment is at least 400 µH, and applicable in practice not more than 1620 µH. The optimum value of capacity *C*ᵣₑₛ depends on the antenna 3 inductance and it is chosen from the mentioned interval in such way that the resonant frequency of the antenna 3 is 125 kHz. Other characteristics of the resonant circuit is voltage at the antenna 3 and a factor of antenna 3 quality. The optimum voltage value at the antenna 3 is in this exemplary embodiment about 60 V, however, for vast majority of technologies in this antenna 3 configuration, voltage of 40 V is fully sufficient. Increase in voltage may lead to increasing of the factor of antenna 3 quality, the optimum value of which is around the value 4, however, the value of 10 is also fully sufficient.

The received signal of the RFID chip 1 is subsequently fed to a resistor with resistance *R*₁, ideally in the range of 80-120 kΩ, wherein the reliable functioning of the device is in this exemplary embodiment also ensured in a wider range of values of 20-200 kΩ, and further to the inverting input of the operational amplifier 4, wherein the output of the first DA converter 6 is also fed to the inverting input of the operational amplifier 4 via the resistor with resistance *R*₂, ideally in the range of values of 2-10 kΩ, while the output of the second DA converter 7 or the source of constant voltage is fed to the non-inverting input of the operational amplifier 4. The operational amplifier 4 is connected in a functional connection of the summing amplifier, and comprises the resistor R_{F}, ideally of the same resistance value as the resistor *R*₁, in a feedback branch interconnecting the inverting input of the operational amplifier 4 with the output of the operational amplifier 4. The minimum value of the resistor *R*₂ is practically determined by load capacity of the first DA converter 6 and the minimum value of resistors *R*₁ and *R*_{F} is given by the limitation for the maximum current by protection diodes of the operational amplifier 4. The values of resistors *R*₁ and *R*_{F} are determined in relation to the chosen value of resistor *R*₂ so that the final signal shift corresponds with the voltage at the antenna 3. The output of the operational amplifier 4 is fed to the input of the AD converter 5 integrated in the MCU unit 14.

In an exemplary embodiment of the invention the operational amplifier 4 has the slew rate of at least 4 V/µs and broadband with a value of at least 8 MHz. However, the invention is not limited to the use of only these parameter values of the operational amplifier 4.

Exemplary use of the device and the method of processing the signal of the passive RFID chip 1 according to this invention is as follows. The reader 2 for processing the signal is a part of a multifunction printer. A user of the printer places a card with the RFID chip 1 on the reader 2 of RFID chips 1. The reader 2 reads information saved on this card. The information may include, for example, user's identification number, their working position, authorization, availability of printing jobs for the given user, etc. Using the method of signal processing according to this invention helps to achieve more reliable and more accurate reading of data, particularly when using RFID chips 1 transmitting a phase modulated signal. In an exemplary embodiment of the invention the parameter values of electrical components in the circuit in Fig. 2 are given as *L*ₐₙₜ*=630* µH, the value of condenser capacity *C*ᵣₑₛ can be chosen in the interval of 1.89-3.16 nF and the values of resistors *R*₁ and *R*₂ then take values of 100 kΩ and 4.7 kΩ, wherein the value of resistor *R*_{F} should be identical to the value of resistor *R*₁. The value of resistance of resistor *R*₁ has to be then chosen with respect to the protection diode of the input of the operational amplifier 4. The value of resistance of resistor *R*₂ has to be then chosen with respect to the load capacity of the first DA converter 6 based on its datasheet. The value of amplification of the operational amplifier 4 is then obtained from the values of resistance of these resistors. However, the invention is not limited to the use of these values, these values are only exemplary. In an exemplary embodiment of the invention a planar antenna 3 from a six-layer printed circuit is chosen as the antenna 3. The same printed circuit comprises simultaneously a low-frequency (LF) and a high-frequency (HF) antenna 3. The advantage of this embodiment lies in a simple manufacture thereof. In addition, the antenna 3 of this type requires no manual assembly, which reduces production complexity and increases the reliability of the device. The specific optimum value of the antenna 3 inductance is therefore given by construction parameters, or the device dimensions. In general, the device reliability increases with higher inductance L. The coefficient of antenna 3 quality Q is in the exemplary embodiment chosen to be 10, optionally 4. However, the specific value of the parameter Q depends on the value of internal inductance and the series resistance of the antenna 3. In the exemplary embodiment with parameters as mentioned above, which is not limiting to other potential embodiments of the invention, the antenna 3 is chosen for voltage at the resonance of 40 V. The value of condenser capacity *C*ᵣₑₛ is then chosen so that the resonant frequency of the circuit is 125 kHz.

Based on the above-mentioned it is apparent that the setting of the optimum parameters is as follows. An antenna 3 with a certain value of internal inductance L is chosen. It is assigned a resonant condenser and the value of the capacity thereof is chosen so that the resonant frequency is 125 kHz for the minimum voltage at the antenna 3 and the corresponding Q. The value of *R*₂ is determined by the load capacity of the first DA converter 6. The values *R*₁ and *R*_{F} are then given by the maximum current passing through the protection diodes of the operational amplifier 4.

In another exemplary embodiment the first DA converter 6 or the second DA converter 7 or the source of constant voltage can be replaced by a PWM (Pulse Width Modulation) channel with a filter designed as a low-pass filter. However, placing the filter to the PWM output slows down the signal and introduces undesirable bias, and it is also very difficult, in this exemplary embodiment, to process signal of the positive and negative half waves at the same time (the so-called two peak sampling).

### Industrial applicability

A device according to this invention can be used to improve quality of data transfer from a LF RFID chip, which is for example in identification cards for attendance records, for identification of components in device during production, or for contactless authorization for devices, such as printers or photocopiers.

### List of reference signs

1 - RFID chip
2 - reader
3 - antenna
4 - operational amplifier
5 - AD converter
6 - first DA converter
7 - second DA converter
8 - first channel DMA
9 - second channel DMA
10 - control unit
11 - synchronizing unit
12 - buffer
13 - queue
14 - MCU

## Claims

1. A method of processing a signal of a passive RFID chip (1) with a reader (2), the reader comprising an antenna (3), an operational amplifier (4), an AD converter (5) and a first DA converter (6) and further a second DA converter (7) or a source of constant voltage, the method consisting of steps of transmitting a source signal from
the antenna (3), and receiving a RFID chip (1) signal by the antenna (3),
**characterized in that**
- the received RFID chip (1) signal and the output of the first DA converter (6) are fed to an inverting input of the operational amplifier (4),
- the output of the second DA converter (7) or the output of the source of constant voltage is fed to a non-inverting input of the operational amplifier (4),
- a first pair of values for controlling the first (6) and the second (7) DA converter or the source of constant voltage is chosen, wherein this pair of values is chosen so that the window of the operational amplifier (4) scans the positive half wave of the received RFID chip (1) signal,
- a second pair of values for controlling the first (6) and the second (7) DA converter or the source of constant voltage is chosen, wherein this pair of values is chosen so that the window of the operational amplifier (4) scans the negative half wave of the received RFID chip (1) signal,
- an output signal from the operational amplifier (4) is fed to the AD converter (5),
- , and by continuously and alternately processing the positive and negative half waves of the received RFID signal by the AD converter to obtain pulse signals and
- subtracting the pulse signals corresponding to the positive and negative half waves from the same wave to obtain a digitally processed signal.

2. The method of processing the signal of the passive RFID chip (1) with the reader (2) according to claim 1 **characterized in that** the values for controlling of the first (6) and the second (7) DA converter or the source of constant voltage are chosen so that the mean value of a useful signal is in the center of an area intended for conversion by the AD converter (5).

3. The method of processing the signal of the passive RFID chip (1) with the reader (2) according to any of the previous claims **characterized in that** the digitally processed signal is stored in a queue (13).

4. A reader (2) for performing the method of processing the signal of the passive RFID chip (1) according to any of the previous claims, the reader further comprising a control unit (10) electrically connected to the antenna (3) and adapted to excite the antenna (3), and a synchronizing unit (11), wherein the synchronizing unit (11) is electrically connected with the first DA converter (6) and further with the second DA converter (7) or the source of constant voltage, the control unit (10) and the AD converter (5), and adapted to time synchronize all components with which it is directly and/or indirectly electrically connected, wherein the outputs of the antenna (3) and the first DA converter (6) are fed to the inverting input of the operational amplifier (4), the output of the second DA converter (7) or the source of constant voltage is fed to the non-inverting input of the operational amplifier (4) and the output of the operational amplifier (4) is fed to the input of the AD converter (5), wherein the operational amplifier (4) is connected as a summing operational amplifier.

5. The reader (2) of the passive RFID chip (1) signal according to claim 4 **characterized in that** the output of the operational amplifier (4) is of a rail-to-rail type.

6. The reader (2) of the passive RFID chip (1) signal according to any of claims 4 and 5 **characterized in that** the control unit (10) comprises a transistor of a push-pull MOSFET type.

## Patentansprüche

1. Ein Verfahren zur Verarbeitung eines Signals eines passiven RFID-Chips (1) mit einem Lesegerät (2), wobei das Lesegerät eine Antenne (3), einen Operationsverstärker (4), einen AD-Wandler (5) und einen ersten DA-Wandler (6) und ferner einen zweiten DA-Wandler (7) oder eine Konstantspannungsquelle umfasst, wobei das Verfahren aus Schritten des Sendens eines Quellsignals von der Antenne (3) und des Empfangens eines RFID-Chip-Signals (1) durch die Antenne (3) besteht, **dadurch gekennzeichnet, dass**
- das empfangene RFID-Chip-Signal (1) und der Ausgang des ersten DA-Wandlers (6) werden einem invertierenden Eingang des Operationsverstärkers (4) zugeführt,
- der Ausgang des zweiten DA-Wandlers (7) oder der Ausgang der Konstantspannungsquelle wird einem nichtinvertierenden Eingang des Operationsverstärkers (4) zugeführt,
- ein erstes Wertepaar zur Steuerung des ersten (6) und des zweiten (7) DA-Wandlers oder die Konstantspannungsquelle gewählt wird, wobei dieses Wertepaar so gewählt ist, dass das Fenster des Operationsverstärkers (4) die positive Halbwelle des empfangenen RFID-Chip-Signals (1) abtastet,
- ein zweites Wertepaar zur Steuerung des ersten (6) und des zweiten (7) DA-Wandlers oder die Konstantspannungsquelle gewählt wird, wobei dieses Wertepaar so gewählt ist, dass das Fenster des Operationsverstärkers (4) die negative Halbwelle des empfangenen RFID-Chip-Signals (1) abtastet,
- ein Ausgangssignal des Operationsverstärkers (4) dem AD-Wandler (5) zugeführt wird,
- und durch kontinuierliches und abwechselndes Verarbeiten der positiven und negativen Halbwellen des empfangenen RFID-Signals durch den AD-Wandler zur Gewinnung von Pulssignalen, und
- Subtrahieren der Pulssignale, die den positiven und negativen Halbwellen entsprechen, von derselben Welle, um ein digital verarbeitetes Signal zu erhalten.

2. Das Verfahren zur Verarbeitung des Signals des passiven RFID-Chips (1) mit dem Lesegerät (2) nach Anspruch 1, **dadurch gekennzeichnet, dass** die Werte zur Steuerung des ersten (6) und des zweiten (7) DA-Wandlers oder der Konstantspannungsquelle so gewählt sind, dass der Mittelwert eines Nutzsignals in der Mitte eines Bereichs zur Umsetzung durch den AD-Wandler (5).

3. Das Verfahren zur Verarbeitung des Signals des passiven RFID-Chips (1) mit dem Lesegerät (2) nach einem der vorhergehenden Ansprüche, **dadurch gekennzeichnet, dass** das digital verarbeitete Signal in einer Warteschlange (13) gespeichert wird.

4. Ein Lesegerät (2) zum Durchführen des Verfahrens zur Verarbeitung des Signals des passiven RFID-Chips (1) nach einem der vorhergehenden Ansprüche, wobei das Lesegerät ferner umfasst
eine Steuereinheit (10), die mit der Antenne (3) elektrisch verbunden ist und dazu eingerichtet ist, die Antenne (3) anzuregen, und
eine Synchronisiereinheit (11), wobei die Synchronisiereinheit (11) mit dem ersten DA-Wandler (6) und ferner mit dem zweiten DA-Wandler (7) oder der Konstantspannungsquelle, der Steuereinheit (10) und dem AD-Wandler (5) elektrisch verbunden ist und dazu eingerichtet ist, alle Komponenten, mit denen sie direkt und/oder indirekt elektrisch verbunden ist, zeitlich zu synchronisieren, wobei die Ausgänge der Antenne (3) und des ersten DA-Wandlers (6) dem invertierenden Eingang des Operationsverstärkers (4) zugeführt werden, der Ausgang des zweiten DA-Wandlers (7) oder der Konstantspannungsquelle dem nichtinvertierenden Eingang des Operationsverstärkers (4) zugeführt wird und der Ausgang des Operationsverstärkers (4) dem Eingang des AD-Wandlers (5) zugeführt wird, wobei der Operationsverstärker (4) als Summierungsoperationsverstärker geschaltet ist.

5. Das Lesegerät (2) des passiven RFID-Chip-Signals (1) nach Anspruch 4, **dadurch gekennzeichnet, dass** der Ausgang des Operationsverstärkers (4) eines Rail-to-Rail-Typs ist.

6. Das Lesegerät (2) des passiven RFID-Chip-Signals (1) nach einem der Ansprüche 4 und 5, **dadurch gekennzeichnet, dass** die Steuereinheit (10) einen Transistor eines Push-pull-MOSFET-Typs umfasst.

## Revendications

1. Un procédé de traitement d'un signal d'une puce RFID passive (1) avec un lecteur (2), où le lecteur comprend une antenne (3), un amplificateur opérationnel (4), un convertisseur A/N (5) et un premier convertisseur N/A (6) et en outre un deuxième convertisseur N/A (7) ou une source de tension constante, où le procédé consiste en des étapes de transmission d'un signal source depuis l'antenne (3), et de réception d'un signal de puce RFID (1) par l'antenne (3), **caractérisé en ce que**
- le signal de puce RFID (1) reçu et la sortie du premier convertisseur N/A (6) sont fournis à une entrée inverseuse de l'amplificateur opérationnel (4),
- la sortie du deuxième convertisseur N/A (7) ou la sortie de la source de tension constante est fournie à une entrée non inverseuse de l'amplificateur opérationnel (4),
- un premier couple de valeurs de commande du premier (6) et du deuxième (7) convertisseur N/A ou de la source de tension constante est choisi, où ce couple de valeurs est choisi de sorte que la fenêtre de l'amplificateur opérationnel (4) balaye la demi-onde positive du signal de puce RFID (1) reçu,
- un deuxième couple de valeurs de commande du premier (6) et du deuxième (7) convertisseur N/A ou de la source de tension constante est choisi, où ce couple de valeurs est choisi de sorte que la fenêtre de l'amplificateur opérationnel (4) balaye la demi-onde négative du signal de puce RFID (1) reçu,
- un signal de sortie provenant de l'amplificateur opérationnel (4) est fourni au convertisseur A/N (5), et en traitant en continu et en alternance les demi-ondes positive et négative du signal RFID reçu par le convertisseur A/N pour obtenir des signaux d'impulsion et
- en soustrayant les signaux d'impulsion correspondant aux demi-ondes positive et négative de la même onde pour obtenir un signal traité numériquement.

2. Le procédé de traitement du signal de la puce RFID passive (1) avec le lecteur (2), selon la revendication 1, **caractérisé en ce que** les valeurs de commande du premier (6) et du deuxième (7) convertisseur N/A ou de la source de tension constante sont choisies pour que la valeur moyenne d'un signal utile soit au centre d'une zone destinée à la conversion par le convertisseur A/N (5).

3. Le procédé de traitement du signal de la puce RFID passive (1) avec le lecteur (2), selon l'une quelconque des revendications précédentes, **caractérisé en ce que** le signal traité numériquement est stocké dans une file d'attente (13).

4. Un lecteur (2) pour effectuer le procédé de traitement du signal de la puce RFID passive (1), selon l'une quelconque des revendications précédentes, où le lecteur comprend en outre
une unité de commande (10) connectée électriquement à l'antenne (3) et adaptée pour exciter l'antenne (3), et
une unité de synchronisation (11), où l'unité de synchronisation (11) est connectée électriquement au premier convertisseur N/A (6) et en outre au deuxième convertisseur N/A (7) ou à la source de tension constante, à l'unité de commande (10) et au convertisseur A/N (5), et adaptée pour synchroniser temporellement tous les composants avec lesquels elle est connectée électriquement directement et/ou indirectement, où les sorties de l'antenne (3) et du premier convertisseur N/A (6) sont fournies à l'entrée inverseuse de l'amplificateur opérationnel (4), la sortie du deuxième convertisseur N/A (7) ou la source de tension constante est fournie à l'entrée non inverseuse de l'amplificateur opérationnel (4) et la sortie de l'amplificateur opérationnel (4) est fournie à l'entrée du convertisseur A/N (5), où l'amplificateur opérationnel (4) est connecté en tant qu'amplificateur opérationnel de sommation.

5. Le lecteur (2) du signal de puce RFID passive (1), selon la revendication 4, **caractérisé en ce que** la sortie de l'amplificateur opérationnel (4) est de type rail-à-rail.

6. Le lecteur (2) du signal de puce RFID passive (1), selon l'une quelconque des revendications 4 et 5, **caractérisé en ce que** l'unité de commande (10) comprend un transistor de type MOSFET push-pull.
